Europäisches Patentamt

European Patent Office

Office européen des brevets

(19)

(11) Publication number: 0 589 090 A1

# EUROPEAN PATENT APPLICATION

(12)

(21) Application number: 92202887.3

(22) Date of filing: 21.09.92

(51) Int. Cl.5: **G06G 7/161**, G01R 21/127

(43) Date of publication of application:
**30.03.94 Bulletin 94/13**

(84) Designated Contracting States:
**AT BE CH DE DK ES FR GB GR IE IT LI LU MC NL PT SE**

(71) Applicant: **MIETEC ALCATEL**
**Westerrring 15**
**B-9700 Oudenaarde(BE)**
Applicant: **Alcatel N.V.**
**De Lairessestraat 153**
**NL-1075 HK Amsterdam(NL)**

(72) Inventor: **Op 't Eynde, Frank Nico Lieven**
**Straetmanshof 11**
**B-3012 Wilsele-Leuven(BE)**

(74) Representative: **Vermeersch, Robert et al**
**BELL TELEPHONE MANUFACTURING**
**COMPANY**
**Naamloze Vennootschap**
**Patent Department**
**Francis Wellesplein 1**
**B-2018 Antwerpen (BE)**

(54) **Signal multiplier device.**

(57) The signal multiplier device SMD multiplies two signals I1 and I2 applied to its input terminals and generates a digital pulse signal OUT proportional to the result of this multiplicaiton at a terminal OUT. It includes a first pulse density modulator PDM1 converting I1 to a 1-bit word signal C which controls a switch S to connect I2 either directly or via an invertor I to an input of a second pulse density modulator PDM2, depending on the value of C.

The device can be included in a device, e.g. an electric energy meter to measure the integral of the product of I1 and I2 or the power of an electric power signal in case of an electric energy meter, in which case I1 is the voltage signal of the electrical power signal, whilst I2 is the current signal or vice-versa. The number of pulses of the digital pulse signal OUT generated during a predetermined time interval is indicative of the power consumption of a user receiver the electric power signal via the meter.

FIG. 1

The present invention relates to a signal multiplier device to multiply a first signal and an analog second signal.

Such a multiplier device is already known in the art and is for instance described in the book "Analog Integrated Circuit Design" by Alan B. Grebene, published by the Van Nostrand Reinhold Company, 1972, and more particularly on pp. 218-234 thereof.

Known signal multipliers such as those described in the latter book are however generally inaccurate and not linear due to offset errors as stated on pp. 218 and 219 of the book, and have to include circuitry to compensate these errors.

An object of the invention is to provide a signal multiplier device of the above type but having an improved accuracy, a better linearity, and a reduced offset error.

This object is achieved due to the fact that it includes :
- a conversion means to convert said first signal to a one-bit word pulse density modulated digital signal having a predetermined bit rate and a first or a second value;
- and a sampling switch controlled at said predetermined bit rate by said one-bit word digital signal to selectively sample said second signal or the inverse thereof depending on said one-bit word digital signal having said first or said second value respectively, thereby producing a sampled third signal indicative of the product of said first and second signals.

It may indeed be shown that the above third signal is the sum of a term proportional to the product of the first and second signals and of error terms which may be reduced to a negligible value by using for example as conversion means a pulse density modulator with a relatively high sampling rate.

Another characteristic feature of the multiplier device according to the invention is that it additionally includes an analog-to-digital second conversion means to convert said sampled third signal to a digital output pulse signal.

The second conversion means thereby generates a signal from which a concrete result value of the multiplication can more easily be derived than from the third signal. Again a pulse density modulator or a multiple byte Sigma-Delta modulator can be used as analog-to-digital conversion means, thus maintaining the advantages resulting from the use of the first pulse density modulator, i.e. the improved linearity, the accurracy and the low offset error.

A further characteristic feature of the multiplier according to the invention is that it is part of a device for determining the integral of the product of said first and analog second signals over a predetermined time interval, said device further including a counter means to count the number of pulses of said digital output pulse signal generated by said second conversion means within said predetermined time interval.

The number of digital pulses over the predetermined interval of the signal generated by the second conversion means is indeed indicative of the integral of the product of the signals applied to the device over the same time interval. Such a device is for instance an electric energy meter to measure the power of an electrical power signal applied to it, said first and analog second signals being indicative of the voltage and of the current of said electrical power signal.

The invention also relates to a device for determining the integral of the product of a first signal and an analog second signal over a predetermined time interval and including a signal multiplier device to multiply said first signal with said analog second signal.

This device is characterized in that said signal multiplier device is as per any of the claims 3 to 5 and that said device additionally includes a counter means to count the number of pulses of said digital output pulse signal generated by said second conversion means within said predetermined time interval.

It is clear that the result of this count is indicative of the mentioned integral. Such a device is for instance an electric energy meter as described above.

The above mentioned and other objects and features of the invention will become more apparent and the invention itself will be best understood by referring to the following description of an embodiment taken in conjunction with the accompanying drawings wherein :

Fig. 1 represents a functional diagram of a signal multiplier device SMD according to the invention; and

Fig. 2 shows an energy meter including the signal multiplier device SMD of Fig. 1.

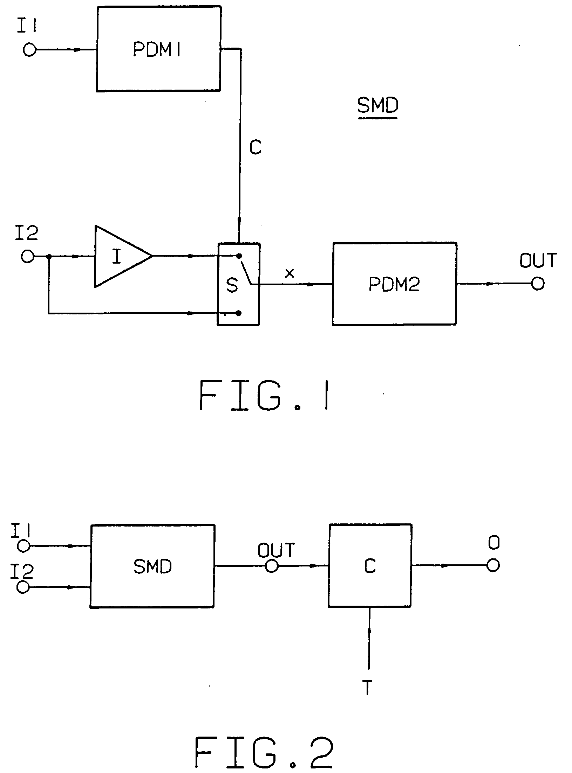

The signal multiplier device SMD of Fig. 1 has input terminals I1, I2 and an output terminal OUT and includes two pulse density modulator circuits, or one-bit sigma-delta modulators PDM1 and PDM2, a change-over sampling switch S and an inverter circuit I. Input terminal I1 is connected to an input of PDM1 whose output C is connected to a control input of S to control S by means of a control signal C. Input terminal I2 is connected to two inputs of S, on the one hand directly and on the other hand via the inverter input I. An output x of S, where a signal x is generated, is connected to an input of PDM2. An output of PDM2 constitutes the output terminal OUT of the device.

One-bit sigma-delta modulators such as PDM1 and PDM2, are generally known in the art. Therefore none of them is described in more detail.

Following is a description of the operation of the above signal multiplier device it being assumed that analog signals I1 and I2 are applied to the like named input terminals I1 and I2.

The analog signal I1 is converted by PDM1 to a one-bit word digital signal C whose value is either equal to +1 or to -1 and the average value of which is proportional to the amplitude of I1. At the rhythm of its bit rate PDM1 controls the sampling switch S. The latter accordingly applies I2 to PDM2 directly when the word value of C is +1 or via I when this word value is -1. Consequently the sampled signal x provided at the output x of S is equal to I2 or to -I2 and therefore to the sampled product of the digital signal C and the analog signal I2. Since C is proportional to I2 this product is also proportional to I1 I2. In PDM2 the sampled signal x is then converted to a one-bit word digital signal OUT.

Following is a mathematical proof of the fact that the signal x as well as the output signal OUT are proportional to the product of I1 and I2.

As generally known the signal C at the output of the modulator PDM1 may be written :

$$C = k1.I1 + e1 \qquad (1)$$

where k1 is the average gain of the modulator PDM1 and e1 is the quantizing error which as a result of the noise shaping operation of the pulse density modulator mainly contains high frequency components inversely proportional to the operation rate of PDM1, the DC value of e1 being zero. The signal x at the output of the switch S may be written as :

$$x = I2 \text{ when } C = 1$$
$$x = -I2 \text{ when } C = -1 \text{ or, in closed form,}$$
$$x = I2.C \qquad (2)$$

Taking the relation (1) into account the signal x thus becomes :

$$x = k1.I1.I2 + e1.I2 \qquad (3)$$

The first term of relation (3) is thus indeed proportional to the product of the signals I1 and I2, whilst the second term thereof represents an error due to the earlier mentioned quantizing error. This second term becomes, as mentioned earlier smaller with increasing operation sampling rate and is minimized by making the latter rate relatively high. The signal OUT may likewise be written as :

$$OUT = k2.x + e2 \qquad (4)$$

Taking the relation (3) into acount the relation (4) becomes :

$$OUT = k2.k1.I1.I2 + k1.e1.I2 + e2 \qquad (5)$$

where I1, I2, e1 and e2 are functions of time.

The first term of relation (5) is thus indeed proportional to the product of I1 and I2. The two other terms of (5) are as the second term of (3) error terms which are function of the above quantizing errors e1 and e2. These terms cause noise of the device, but may be made negligibly small by making the sampling rates of the modulators relatively high, as explained earlier. Their time-average (DC value) is zero.

It has to be noted that instead of being an analog signal I1 may be a multiple-bit word digital signal, or even a one-bit word digital signal, the signal x being then the product of a multiple-bit or a one-bit word digital signal with an analog signal.

The electric energy meter of Fig. 2 measures the electric energy a subscriber has consumed over a predetermined time interval, said subscriber receiving an electric power signal via said meter. It includes the signal multiplier device SMD of Fig. 1, and a counter circuit C. The terminal OUT of SMD is connected to an input of C which is controlled by a signal T and which generates at a like-named terminal an output signal 0. If the signals I1 and I2 applied to SMD are the voltage and current of the electrical signal, then OUT is indicative of the corresponding power thereof. By counting in C the number of pulses generated at OUT during a predetermined period, a measure is thus obtained of the power consumption of the mentioned subscriber during that period. The result of this count is generated at O and T controls C to start counting at the beginning of the latter time interval and to generate O and reset the count at the end of the interval.

It has to be noted that in this electric energy meter only the DC value of the voltage-current product is of importance. Since e1 and e2 of expression (5) contain no DC part, the DC value of (5) indeed corresponds to the required product, i.e. it is proportional to the electric energy of the electrical signal producing I1 and I2.

It has also to be noted that a meter as described above can be used to determine the integral of the product of any other type of signals applied to I1 and I2.

While the principles of the invention have been described above in connection with specific apparatus, it is to be clearly understood that this description is made only by way of example and not as a limitation on the scope of the invention.

## Claims

1. Signal multiplier device to multiply a first signal (I1) and an analog second signal (I2), characterized in that it includes :
   - a conversion means (PDM1) to convert said first signal (I1) to a one-bit word pulse density modulated digital signal (C) having a predetermined bit rate and a first or a second value;
   - and a sampling switch (S) controlled at said predetermined bit rate by said one-bit word digital signal (C) to selectively sample said second signal or the inverse thereof depending on said one-bit word digital signal (C) having said first or said second value respectively, thereby producing a sampled third signal (x) indicative of the product of said first and second signals.

2. Signal multiplier device according to claim 1, characterized in that said conversion means is constituted by a pulse density modulator (PDM1).

3. Signal multiplier device according to claim 1, characterized in that it additionally includes an analog-to-digital second conversion means (PDM2) to convert said sampled third signal (x) to a digital output pulse signal (OUT).

4. Signal multiplier device according to claim 3, characterized in that said second conversion means is constituted by a second pulse density modulator (PDM2).

5. Signal multiplier device according to claim 3, characterized in that said second conversion means is constituted by a multiple bit Sigma-Delta modulator.

6. Signal multiplier device according to claim 3, characterized in that it is part of a device for determining the integral of the product of said first and analog second signals over a predetermined time interval, said device further including a counter means (C) to count the number of pulses of said digital output pulse signal (OUT) generated by said second conversion means (PDM2) within said predetermined time interval.

7. Signal multiplier device according to claim 6, characterized in that said device is an electric energy meter to measure the power of an electrical power signal applied to it, said first (I1) and analog second (I2) signals being indicative of the voltage and of the current of said electrical power signal.

8. Device for determining the integral of the product of a first signal (I1) and an analog second signal (I2) over a predetermined time interval and including a signal multiplier device (SMD) to multiply said first signal (I1) with said analog second signal (I2), characterized in that said signal multiplier device is as per any of the claims 3 to 5 and that said device additionally includes a counter mens (C) to count the number of pulses of said digital output pulse signal (OUT) generated by said second conversion means (PDM2) within said predetermined time interval.

9. Device according to claim 8, characterized in that it is an electric energy meter to measure the power of an electrical power signal applied to it and that said first signal (I1) and said analog second (I2) signals are indicative of the voltage and of the current of said electrical power signal.

FIG. 1

FIG.2

European Patent Office

**EUROPEAN SEARCH REPORT**

Application Number

EP  92 20 2887

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | US-A-3 655 955 (BRENDLE) | 1-3,6-9 | G06G7/161 |
| Y | * column 2, line 7 - line 43 * | 4 | G01R21/127 |
| | * column 2, line 51 - line 75 * | | |
| | * column 3, line 19 - line 30; figures 1-3 * | | |
| | --- | | |
| Y | US-A-3 546 441 (BRENDLE) | 4 | |
| | * column 2, line 5 - line 30 * | | |
| | * column 5, line 4 - line 12; figures 1,6 * | | |
| | --- | | |
| A | EP-A-0 434 248 (GEC) | 1,5 | |
| | * abstract; figure 1 * | | |
| | --- | | |
| A | EP-A-0 272 504 (SIEMENS) | 3,6-9 | |
| | * abstract; figure 1 * | | |
| | ----- | | |
| | | | TECHNICAL FIELDS SEARCHED (Int. Cl.5 ) |
| | | | G06G |
| | | | G01R |

The present search report has been drawn up for all claims

| Place of search | Date of completion of the search | Examiner |
|---|---|---|
| THE HAGUE | 24 MAY 1993 | IWANSSON K.G. |

EPO FORM 1503 03.82 (P0401)